# EUROPEAN PATENT APPLICATION

(11) **EP 2 555 255 A2**
(43) Date of publication of application: **06.02.2013**
(21) Application number: 12178507.5
(22) Date of filing: 30.07.2012
(51) Int. Cl.: H01L 33/14

(54) **Light emitting diode structure and manufacturing method thereof**

(30) Priority: 01.08.2011 TW 100127247
(71) Applicant: Lextar Electronics Corp., 30075 Hsinchu (TW)
(72) Inventor: Chen, Cheng-Hung, 330 Taoyuan County (TW)
(74) Representative: von Kreisler Selting Werner

(57) **Abstract**

A light emitting diode structure and a manufacturing method thereof are disclosed. The structure includes a substrate, an N type semiconductor layer, and active layer, a P type semiconductor layer, a current diffusion layer, and a metal electrode. The metal ions of the P type semiconductor layer may bond with hydrogen after process thermal annealing, and metal hydride may be generated. The metal hydride may be directly formed on the surface of the P type semiconductor layer and may be used as the current blocking layer. Since the metal hydride may be directly formed on the surface of the P type semiconductor layer, its structure is flat, which resolve the problem having the electrodes peeled off from the solder wire.

## Description

### BACKGROUND OF THE INVENTION

### 1. Field of the Invention

The present invention relates to a light emitting diode structure; in particular, to a light emitting diode structure and a manufacturing method thereof which use metal hydride as a current blocking layer.

### 2. Description of Related Art

The light emitting diode (LED) is mainly combined by P type and N type semiconductor materials, which may generate self-radiating light within the optical spectrums of ultra-violate light, visible light, and infrared light. Generally, the visible light LED is used as an indicator or illumination of electronic apparatus and equipments, and the infrared LED is used in optical fiber communications. At first, the LEDs are usually used as indicators or displayers, but along with the appearance of white light LEDs, they may also be used in illuminations. Because the LED has the advantages of energy saving, long lifetime, and high brightness, under the trend of eco-friendly and low carbon economy issues, the applications of LED is spreading. For example, the traffic lights, the street lamps, the electric torch, and the backlight modules of the liquid crystal display.

Many improvements and adjustments on the structures of the LED are for increasing the light extraction efficiency of the LED. One of the adjustments is disposing a current blocking layer between the transparent electrode and the epitaxy layer (such as a P type semiconductor layer). The current blocking layer is usually formed by silicon nitride or silicon oxide. Because the silicon nitride or the silicon oxide has relatively large thickness, the metals disposed thereon may be easily peeled off, which causes reduction in the manufacturing process yield.

### SUMMARY OF THE INVENTION

The object of the present invention is to provide a light emitting diode structure and a manufacturing method thereof. The structure and method use metal hydride formed by thermal annealing manner as a current blocking layer. Because the metal hydride is directly formed on the surface of a P type semiconductor layer, the thickness thereof is smaller than the current blocking layer formed by silicon oxide or silicon nitride. Thus, the current blocking efficiency of the isolation layer may be increased, and the problem that the upper electrode is peeling off the solder wire may be improved.

An embodiment of the present invention provides a light emitting diode structure which has a substrate, an N type semiconductor layer, an active layer, a P type semiconductor layer, a current diffusion layer, and a metal electrode. It's worth noting that a current blocking layer generated after doping metal ions bond with hydrogen is located between the P type semiconductor layer and the current diffusion layer, for blocking current from passing through a region of a current blocking layer.

Another embodiment of the present invention provides a manufacturing method of a light emitting diode structure. The method includes steps of providing a substrate, and forming a light emitting diode structure mesa on the substrate. The mesa includes at least an N type semiconductor layer, an active layer, and a P type semiconductor layer. The method further includes steps of using silane or disilane as a reaction gas for forming an isolation layer on the P type semiconductor layer, generating a bonding between hydrogen of the isolation layer and metal ions of the P type semiconductor layer by the use of the thermal annealing for forming a current blocking layer on a surface of the P type semiconductor layer, forming a current diffusion layer covering the current blocking layer, and forming a first metal electrode on the current diffusion layer.

On the basis of the above, the present invention uses metal hydride formed by using thermal annealing as a current blocking layer. Thus the embodiments of the present invention may slim the thickness of the isolation layer while remaining the original capability of current blocking, which may resolve the problem of having the upper electrode peeled off from the solder wire.

For further understanding of the present disclosure, reference is made to the following detailed description illustrating the embodiments and examples of the present disclosure. The description is only for illustrating the present disclosure, not for limiting the scope of the claim.

### BRIEF DESCRIPTION OF THE DRAWINGS

The drawings included herein provide further understanding of the present disclosure. A brief introduction of the drawings is as follows:

FIGS. 1A to 1F show schematic diagrams of a manufacturing process of a light emitting diode structure according to a first embodiment of the present invention;

FIG. 2 shows a structure diagram of a current blocking layer according to an embodiment of the present invention;

FIG. 3 shows a flow chart of a manufacturing method of a light emitting diode structure according to an embodiment of the present invention;

FIGS. 4A to 4E show a schematic diagram of a manufacturing process of a light emitting diode structure according to an embodiment of the present invention; and

FIG. 5 shows a flow chart which omits a step of removing an isolation layer 130 according to an embodiment of the present invention.

### DETAILED DESCRIPTION OF THE PREFERRED EMBODIMENTS

The aforementioned illustrations and following detailed descriptions are exemplary for the purpose of further explaining the scope of the present invention. Other objectives and advantages related to the present invention will be illustrated in the subsequent descriptions and appended drawings.

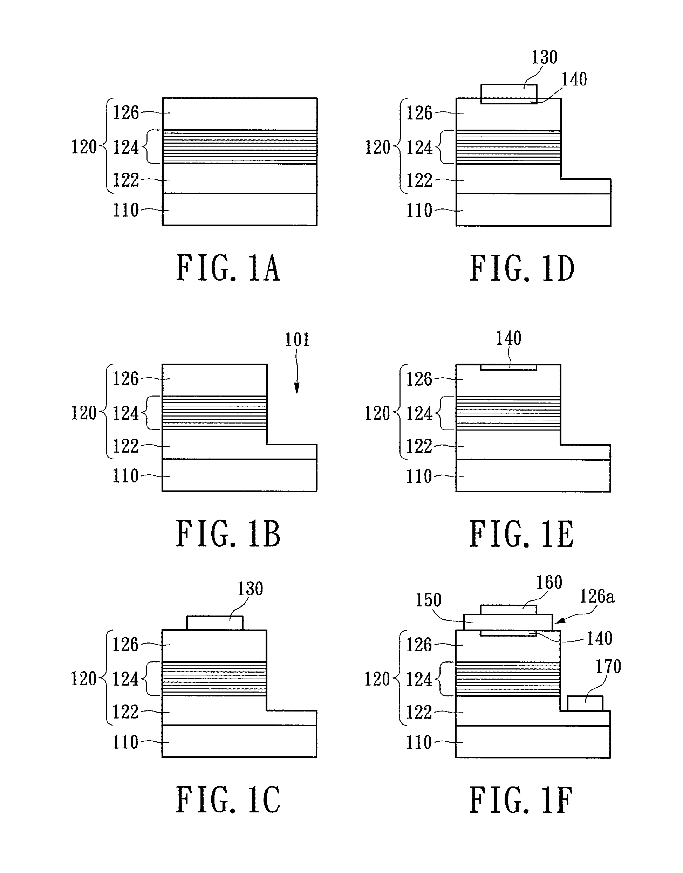

Please refer to FIGS. 1A to 1F which show schematic diagrams of manufacturing processes of a light emitting diode (LED) structure according to an embodiment of the present invention. The LED structure includes a substrate 110, an epitaxy layer 120, a current blocking layer 140, a current diffusion layer 150, and metal electrodes 160 and 170. The epitaxy layer 120 includes an N type semiconductor layer 122, an active layer 124, and a P type semiconductor layer 126. The N type semiconductor layer 122, the active layer 124, and the P type semiconductor layer 126 are formed on the substrate 110, as shown in FIG. 1A. The materials of the substrate 110 may be sapphire, GaP, GaAs, AlGaAs, or SiC. In this embodiment, the substrate 110 uses sapphire as an example, and a crystal lattice orientation may be (0001). It's worth noting that the materials of the substrate and the orientation of the crystal lattice may not be limited thereby.

A buffer layer (not shown) locates between the substrate 110 and the N type semiconductor layer 122 may be aluminum gallium nitride (AlGaN), but the embodiment is not limited thereby. The epitaxy layer 120 may be formed through adopting the metal organic chemical-vapor deposition (MOCVD), the liquid phase epitaxy (LPE), or the molecular beam epitaxy (MBE), and this embodiment is not limited thereof. When the epitaxy layer 120 is formed by the metal organic chemical-vapor deposition, reaction gases containing deposition materials may be induced into a reaction room for depositing the epitaxy layer 120. The mentioned reaction gases may be silane (SiH₄) or disilane (H₆Si₂). The N type semiconductor layer 122 may be formed by silicon-doping aluminum gallium indium phosphide materials or silicon-doping gallium nitride materials. The P type semiconductor layer 126 may be formed by magnesium-doping aluminum gallium indium phosphide materials or magnesium-doping gallium nitride materials. The active layer 124 may be multi-quantum well (MQW) structure, such as indium gallium nitride /gallium nitride (In_{0.3}Ga_{0.7}N/GaN) quantum well structure.

After the epitaxy layer 120 is formed, the structure of the epitaxy layer 120 may be defined by photolithography or etching processes, for forming a light emitting diode structure mesa 101. Parts of the N type semiconductor layer 122, the active layer 124, and the P type semiconductor layer 126 of the epitaxy layer 120 may be removed to expose part of the structure of the N type semiconductor layer 122, as shown in FIG. 1B.

The isolation layer 130 may be silicide, such as silicon oxide or silicon nitride. The forming method thereof may use silane or disilane as reaction gas, and forming the silicide on the P type semiconductor layer 126 by using the epitaxy method, as shown in FIG. 1C. Since the silane or disilane contains hydrogen ions and the hydrogen ions are used as carrier gas during the reaction process, hence the isolation layer 130 may capture some of hydrogen ions or hydrogen gases. Then by using thermal processes (or thermal annealing), the metal ions (such as magnesium ions) which is doped in the P type semiconductor layer 126 may be bonded with hydrogen, and may generate magnesium-hydrogen complex (Mg-H complex). The annealing temperature of the thermal processes may be in the range of 500 °C to 600 °C, and the reaction time thereof may be 5 minutes.

The Mg-H complex may lower the concentration of the electric hole in the P type semiconductor layer 126, which may increase the resistance of this region, to form a current blocking layer 140. There are various types of compounds generated by the magnesium ions and the hydrogen ions, including MgH, MgH₂, Mg₂H, Mg₂H₂, Mg₂H₃, and Mg₂H₄, but the disclosed Mg-H compounds of the embodiment is not limited to the examples described herein. The Mg-H complex may decrease the amount of current passing through the current blocking layer 140, thereby achieving the objective of current blocking. In other words, the instant embodiment directly replaces the conventional silicide with the formation of metal hydride on the surface of the P type semiconductor layer 126, to serve as the current blocking layer. It is worth noting that the doping metal ions of the P type semiconductor layer 126 are not limited to magnesium ions. Alternatively, any ions such as beryllium (Be) ions, calcium (Ca) ions, or barium (Ba) ions that are able to provide concentration of electric hole may be used to bond with hydrogen to form the current blocking layer.

After the isolation layer 130 is removed, it may be seen that the current blocking layer 140 is directly formed on the surface of the P type semiconductor layer 126, and its surface is flat, i.e., the surface does not have any protrude structures, as shown in FIG. 1E. The removing techniques may include etching processes, chemical-mechanical polishing (CMP), or buffered oxide etch (BOE), and the scope of the present invention is not limited thereby. The current diffusion layer 150 may be directly formed on the P type semiconductor layer 126 for covering the current blocking layer 140, as shown in FIG. 1F. The techniques for forming the current diffusion layer 150 may include electron beam evaporation or sputtering deposition, but the scope of the present invention is not limited thereby. The current diffusion layer 150 may be formed by using materials with low resistance, which may cause the current easily diffuses to the sides, and the materials may be indium tin oxide (ITO), aluminum zinc oxide (AZO), tin oxide (SnO), cadmium tin oxide (CTO), antimony tin oxide (ATO), and nickel/gold (Ni/Au), etc, but the present embodiment is not limited thereby. In addition, the contact layer (not shown) between the current diffusion layer 150 and the P type semiconductor layer 126 may be short period superlattice gallium nitride (GaN SPS), but the present embodiment is not limited thereby.

The metal electrodes 160 and 170 are formed on the current diffusion layer 150 and the N type semiconductor layer 122 respectively, and are used as positive and negative electrodes. The current diffusion layer 150 may evenly distribute the current flow toward the regions other than the region of the metal electrode 160. Referring to FIG. 1F, the current blocking layer 140 is directly formed on the contact surface between the P type semiconductor layer 126 and the current diffusion layer 150, with the location and shape thereof in correspondence to the metal electrode 160. The current blocking layer 140 may prevent the current from directly passing through the underneath area of the metal electrode 160 into the P type semiconductor layer 126, thereby may reduce the possibility of recombination the electron and the electric hole. Therefore, the light emitting efficiency of the regions other than the metal electrode 160 may be increased.

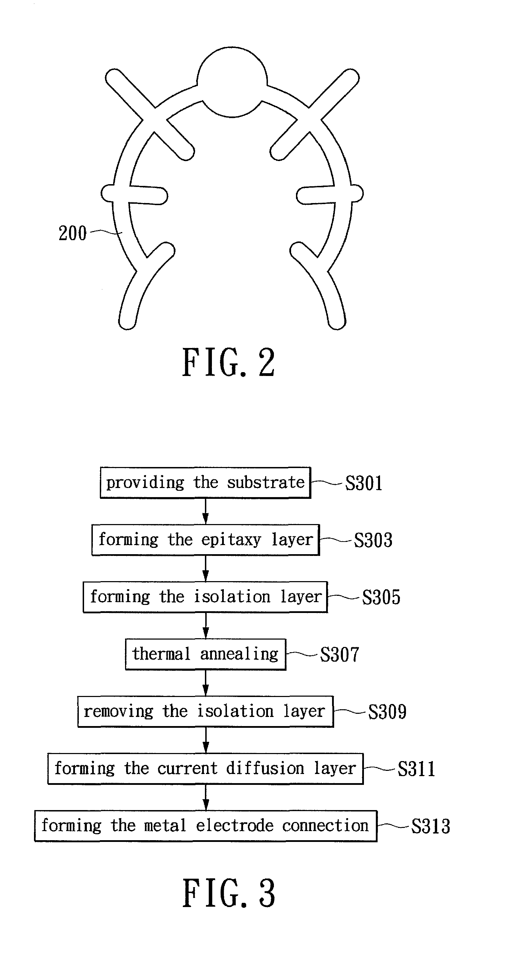

Since the current blocking layer 140 is directly formed on the contact surface 126a between the P type semiconductor layer 126 and the current diffusion layer 150, its surface is flat, and the thickness thereof is much smaller than the current blocking layer formed by silicon oxide and silicon nitride. Therefore, the problem that the metal electrode 160 may be peeled off from solder wire may be resolved. In addition, the structure of the current blocking layer 140 may be implemented by several embodiments, as shown in FIG. 2 which is a structure diagram of a current blocking layer according to an embodiment of the present invention. The shape of the structure 200 of current blocking layer may be designed according to actual requirements for increasing the light emitting efficiency. It is worth noting that the current blocking structure of the present invention is not limited by FIG. 2.

In addition, from the aforementioned descriptions of FIGS. 1A to 1F, a manufacturing method of a light emitting diode may be induced, as shown in FIG. 3 which is a flow chart of a manufacturing method of a light emitting diode according to an embodiment of the present invention. First, provides a substrate 110 (step S301), and forming a LED structure mesa 101 on the substrate 110. The LED structure mesa 101 may include at least an N type semiconductor layer 122, an active layer 124, and a P type semiconductor layer 126 (step S303). After that, forming an isolation layer 130 on the P type semiconductor layer 126 by using silane or disilane as reaction gases (step S305), then process a thermal annealing processes. The reaction time of the annealing of this embodiment may be 5 minutes, and the associated annealing temperature may be 500 °C to 600 °C, which may cause the hydrogen of the isolation layer 130 to bond with the metal ions of the P type semiconductor layer 126 to form a current blocking layer 140 (step S307). Next, removing the isolation layer 130 from the P type semiconductor layer 126 (step S309), then forming a current diffusion layer 150 to cover the current blocking layer 140 (step S311). Lastly, forming a first metal electrode 160 on the current diffusion layer 150 and forming a second electrode 170 connecting the N type semiconductor layer 122 (step S313). The remaining details of the aforementioned manufacturing method of the light emitting diode structure may be known by the one skilled in the art, thus the details description may therefore omitted.

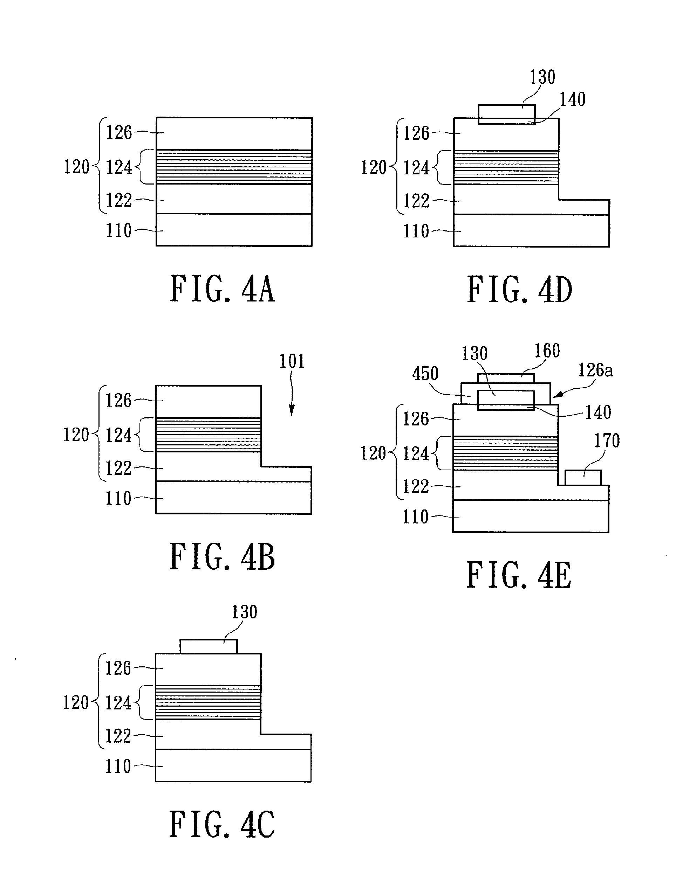

In another embodiment of the present invention, the isolation layer 130 may be kept on the current blocking layer 140 for enhancing the efficiency of current blocking. In other words, there may have two layers for current blocking between the current diffusion layer 150 and the P type semiconductor layer 126: one is the current blocking layer 140 and the other one is the isolation layer 130. Please refer to FIGS. 4A to 4E which show schematic diagrams of manufacturing processes of a LED structure according to another embodiment of the present invention. Please also refer to FIGS. 1A to 1F along with FIGS. 4A to 4E. The descriptions of FIGS. 1A to 1D are similar to the descriptions in FIGS. 1A to 1D, thus the following embodiments may not describe them again.

The differences between the FIGS. 4A to 4E and FIGS. 1A to 1F are that in FIGS. 4A to 4E, the step of removing the isolation layer 130 is omitted (as shown in FIG. 1 E), and the current diffusion layer 450 is directly formed for covering the isolation layer 130, as shown in FIG. 4E. The preferred thickness of isolation layer 430 is smaller than 10,000 angstrom (A). However. the thickness of the isolation layer 430 in the present invention is not limited thereby.

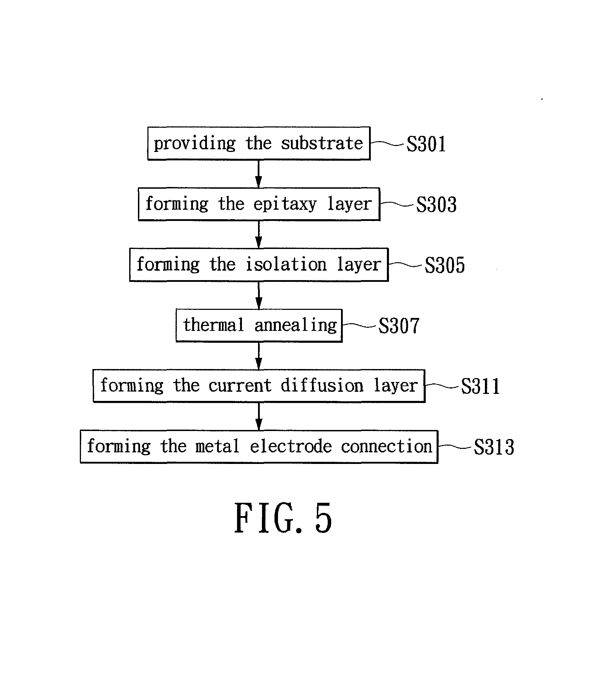

Please also refer to FIG. 5 which shows a flow chart of omitting the step on removing the isolation layer 130 according to an embodiment of the present invention. The difference between FIG. 5 and FIG. 3 is that the step S309 of removing isolation layer is omitted. That is, the isolation layer 130 is preserved for being used as a current blocking layer, and the current blocking layer 140 which includes Mg-H complex is formed on the contact surface between the isolation layer 130 and the P type semiconductor layer 126.

It is worth noting that the current blocking layer 140 formed by Mg-H complex between the isolation layer 130 and the P type semiconductor layer 126 may increase the efficiency of current blocking of the isolation layer 130, that is, the insulation ability may be enhanced. Therefore, in comparison with the conventional techniques, the disclosed embodiment may use thinner isolation layer 130 for achieving the same efficiency of current blocking, and may also resolve the problem having the upper electrode peeled off from the solder wire. In addition, the current blocking layer 140 may also resolve the problem of current leakage of the isolation layer 130.

On the basis of the aforementioned descriptions, the present invention uses the metal hydride generated after the hydrogen of the isolation layer and the metal ions of the P type semiconductor layer pass thermal processes for increasing the efficiency of current blocking of the isolation layer, and also for replacing the isolation layer and being used as a current blocking layer. In addition, the reduction of the thickness of the isolation layer or the removal of the isolation layer may resolve the problem of having the upper electrode peeled off from the solder wire.

Some modifications of these examples, as well as other possibilities will, on reading or having read this description, or having comprehended these examples, will occur to those skilled in the art. Such modifications and variations are comprehended within this disclosure as described here and claimed below. The description above illustrates only a relative few specific embodiments and examples of the present disclosure. The present disclosure, indeed, does include various modifications and variations made to the structures and operations described herein, which still fall within the scope of the present disclosure as defined in the following claims.

## Claims

1. A light emitting diode structure having a substrate, an N type semiconductor layer, an active layer, a P type semiconductor layer, a current diffusion layer, and a first metal electrode, wherein a current blocking layer capable of blocking current there-through is formed between the P type semiconductor layer and the current diffusion layer through bonding of metal ions that are doped into the P type semiconductor layer and hydrogen.

2. The light emitting diode structure according to claim 1, wherein a location of the current block layer is corresponding to a location of the first metal electrode for blocking the current from passing through the current blocking layer.

3. The light emitting diode structure according to claim 1, wherein part of the current diffusion layer is formed directly on the current blocking layer.

4. The light emitting diode structure according to claim 1, wherein the N type semiconductor layer is formed on the substrate, the active layer is formed between the N type semiconductor layer and the P type semiconductor layer, the current blocking layer is formed on the P type semiconductor layer and is deposed between the current diffusion layer and the P type semiconductor layer, and the first metal electrode is formed on the P type semiconductor layer.

5. The light emitting diode structure according to claim 1, further comprising a second metal electrode connecting to the N type semiconductor layer.

6. The light emitting diode structure according to claim 1, wherein the doping metal ions of the P type semiconductor layer include magnesium ions, and the current clocking layer is formed of a magnesium-hydrogen complex.

7. The light emitting diode structure according to claim 1, wherein an isolation layer disposed between the P type semiconductor layer and the current diffusion layer is formed of silicides, and the isolation layer is formed on the current blocking layer.

8. The light emitting diode structure according to claim 7, wherein a thickness of the isolation layer is smaller than 10,000 Å.

9. A manufacturing method of a light emitting diode structure, comprising:
providing a substrate;
forming a light emitting diode structure mesa on the substrate, wherein the light emitting diode structure mesa includes at least an N type semiconductor layer, an active layer, and a P type semiconductor layer;
using silane or disilane as a reaction gas for forming an isolation layer on the P type semiconductor layer;
generating a bonding between hydrogen of the isolation layer and metal ions of the P type semiconductor layer by using thermal annealing process, to generate a current blocking layer on a surface of the P type semiconductor layer;
forming a current diffusion layer which covers on the current blocking layer; and
forming a first metal electrode on the current diffusion layer.

10. The manufacturing method of the light emitting diode structure according to claim 9, wherein in the step of processing thermal annealing, an annealing temperature of thermal annealing is in the rage of 500 °C to 600 °C, and an associated reaction time of thermal annealing is 5 minutes.

11. The manufacturing method of the light emitting diode structure according to claim 9, further comprising:
forming a second metal electrode for connecting to the N type semiconductor layer.

12. The manufacturing method of the light emitting diode structure according to claim 9, wherein the light emitting diode structure mesa is formed by using epitaxy manufacturing processes which uses hydrogen as a current carrier gas.

13. The manufacturing method of the light emitting diode structure according to claim 9, wherein the doped metal ions in the P type semiconductor layer include magnesium ions, and the current blocking layer is formed of a magnesium-hydrogen complex.

14. The manufacturing method of the light emitting diode structure according to claim 9, wherein the isolation layer is silicon nitride.

15. The manufacturing method of the light emitting diode structure according to claim 9, wherein prior to the formation of the current diffusion layer, further comprises removing of the isolation layer.
